# NEW EUROPEAN PATENT SPECIFICATION

(11) **EP 1 887 633 B2**
(45) Date of publication and mention of the opposition decision: **22.06.2016**
(45) Mention of the grant of the patent: 10.08.2011
(21) Application number: 06745924.8
(22) Date of filing: 01.05.2006
(51) Int. Cl.: H01L 31/0224

(54) **SOLAR CELL AND SOLAR CELL MANUFACTURING METHOD**
SOLARZELLE UND SOLARZELLEN-HERSTELLUNGSVERFAHREN
CELLULE SOLAIRE ET PROCEDE DE FABRICATION D UNE CELLULE SOLAIRE

(30) Priority: 01.06.2005 JP 2005161251
(43) Date of publication of application: 13.02.2008
(73) Proprietor: Shin-Etsu Handotai Co., Ltd., Tokyo (JP); Shin-Etsu Chemical Company, Ltd., Tokyo 100-0004 (JP)
(72) Inventor: OJIMA, Satoyuki, c/o Isobe R&D Center, Shin-Etsu Handotai Co.,Ltd., Annaka-shi, Gunma 3790196 (JP); ISHIKAWA, Naoki, c/oIsobe R&D Center, Shin-Etsu Handotai Co. Ltd., Annaka-shi, Gunma 3790196 (JP)
(74) Representative: Wibbelmann, Jobst
(86) International application number: PCT/JP2006/309073
(87) International publication number: WO 2006/129446

(56) References cited:
- DE-A1-102004 049 160
- JP-A- 02 235 379
- JP-A- 06 061 515
- JP-A- 06 209 114
- JP-A- 09 008 337
- JP-A- 09 260 696
- JP-A- 10 163 512
- JP-A- 11 307 792
- JP-A- 2003 142 703
- JP-A- 2005 101 426

## Description

### TECHNICAL FIELD

The present invention relates to solar cells including at least a semiconductor substrate formed with a PN-junction, a finger electrode formed comb-like at least on one side of the semiconductor substrate, and a bus bar electrode connected to the finger electrode on the semiconductor substrate, and in particular, it relates to a high-efficiency solar cell in which a connector to be attached is hard to peel off and the shielding of the sunlight is small.

### BACKGROUND ART

In general, the solar cell is formed with a comb-like finger electrode to take out a power from the semiconductor substrate on a light receiving surface of the semiconductor substrate formed with a PN-junction and a bus bar electrode to be connected to and take out a power from the comb-like finger electrode.

The bus bar electrode is attached with a connector by solder, for example, to mutually connect the solar cells.

Since this bus bar electrode makes a shadow when the sunlight enters the substrate, the electrode width is required to be narrowed down.

However, narrowing down an electrode width of the bus bar electrode creates a problem that the surface area of the bus bar electrode becomes small, and the contact area with solder attached to the connector and the bus bar electrode is reduced, so that adhesive strength is lowered and the attached connector is easily peeled off.

In contrast to this, a method for preventing the attached connector from being peeled off by enlarging the surface area of the bus bar electrode and attaching a lot of solder at the end or the intermediate portion of the bus bar electrode is disclosed (see Japanese Patent Application Laid-Open Publication No. 2000-188409). Document DE 10 2004 049160 A discloses solar cells with electrodes of specific geometry.

However, in this method, since the bus bar electrode increases the area that shuts out the sunlight, the efficiency of the solar cell is reduced.

### DISCLOSURE OF THE INVENTION

Hence, the present invention has been made in view of the problem, and an object of the invention is to provide a low cost and high efficiency solar cell in which a connector attached to a bus bar electrode is hard to peel off and the shielding of the sunlight by the bus bar electrode is small, and a method for manufacturing the same.

To achieve the object, according to the present invention, a solar cell is provided, as recited in claim 1. Further advantageous embodiments are recited in the dependent claims 2-5.

In this manner, the bus bar electrode is formed with the recess-and-projection pattern on the surface, so that the contact area with the solder that attaches the connector is increased, thereby increasing adhesive strength between the bus bar electrode and the connector. Hence, there is no need to widen the width of the bus bar electrode, and this enables the shielding of the sunlight by the bus bar electrode to be reduced so as to create a low cost and high efficiency solar cell.

In this manner, when the pattern shape of the recess-and-projection pattern is any shape of a stripe shape, a mesh shape, a honeycomb shape, and a point shape, the solder flow between the recesses and projections, and the contact area of both sides increases, and the electrode and the solder can be firmly adhered. Particularly, when the shape is the mesh shape or the honeycomb shape, the difference in the directional character of the difficulty to peel off the connector can be eliminated, and when the pattern shape is the dot, a quantity consumed of the electrode material can be reduced.

The interval between the projections among the recesses and projections is preferably set to 50 *µ*m to 1 mm.

In this manner, the interval between the projections among the recesses and projections is set 50 *µ*m to 1 mm, so that the contact area is increased, and the solder can surely flow between the recesses and projections of the electrode surface, thereby making it possible to surely improve the adhesive strength.

The bus bar electrode is preferably between 1 mm and 2 mm in width and not more than 80 *µ*m in thickness.

In this manner, such a bus bar electrode is 1 mm to 2 mm in width and is below 80 *µ*m in thickness, so that the electrode area shutting off the sunlight can be made sufficiently small, and a quantity consumed of the electrode material can be also suppressed small, while the electrode surface area wide enough to be connected can be obtained.

The bus bar electrode comprises two-layers, and on the basis of at least one layer of the two layers of the bus bar electrode, a pattern shape of the recess-and-projection pattern is formed.

In this manner, the bus bar electrode is made of two layers, so that, on the basis of at least one layer thereof, the pattern shape of the recess-and-projection pattern can be easily formed.

The bus bar electrode is preferably printed with a conductive paste and fired.

In this manner, such a bus bar electrode is printed with a conductive paste and fired, so that the manufacturing yield of a low cost and high efficiency solar cell can be improved. When the bus bar electrode is fabricated by using the conductive paste and the connector is soldered, a problem of the connector being peeled off is liable to occur, and for this reason, the present invention is particularly effective.

The semiconductor substrate is preferably a p-type single crystal silicon substrate doped with gallium.

In this manner, such a semiconductor substrate is turned into a p-type single crystal silicon substrate doped with gallium, so that a practical solar cell having extremely high photovoltaic conversion efficiency without causing light degradation can be achieved.

According to the present invention, a manufacturing method for a solar cell is provided, as recited in claim 6.

In this manner, by printing the conductive paste and firing twice, the bus bar electrode of the two-layered structure is formed, and at least by one printing and firing from among the two printings and firing, the recess-and-projection pattern is formed on the surface of the bus bar electrode of the two-layered structure, so that a low cost and high efficiency solar cell with the connector soldered to the bus bar electrode not peeled off can be easily manufactured.

In this manner, if a solar cell is a kind of the solar cell of the present invention, without enlarging a width of the bus bar electrode, the surface area of the bus bar electrode can be made large, so that the contact area with the solder that attaches the connector increases, thereby to increase adhesive strength, and this makes the connector hard to be peeled off, and moreover, because the width of the bus bar electrode is narrow, a low cost and high efficiency solar cell with the shielding of the sunlight made small can be obtained.

### BRIEF DESCRIPTION OF DRAWINGS

FIG. 1 shows a solar cell according to an example not forming part of the claimed invention, and is a schematic top plan view of an example in which the pattern shape of a recess-and-projection pattern formed on the surface of a bus bar electrode is a mesh shape;
FIG. 2 shows a solar cell according to an example not forming part of the claimed invention, and is a perspective view showing a schematic cross section of an example in which the pattern shape of a recess-and-projection pattern formed on the surface of a bus bar electrode is a stripe shape;
FIG. 3 shows a solar cell according to an example not forming part of the claimed invention, and is a perspective view showing a schematic cross section of an example in which the pattern shape of a recess-and-projection pattern formed on the surface of a bus bar electrode is a mesh shape; and
FIG. 4 shows a solar cell according to the present invention, and is a perspective view showing a schematic cross-section of an example in which the pattern shape of a recess-and-projection pattern formed on the surface of a bus bar electrode is a point shape.

### BEST MODE FOR CARRYING OUT THE INVENTION

Since a bus bar electrode makes a shadow when the sunlight enters a substrate, an electrode width is required to be narrowed down. However, narrowing down a width of the bus bar electrode creates a problem in that a contact area between the bus bar electrode and a connector is reduced, so that adhesive strength is lowered and the connector attached by the solder is easily peeled off.

Hence, the present inventors have made a strenuous study and found that a solar cell including at least a semiconductor substrate formed with a PN-junction, a finger electrode formed comb-like on at least one side of the semiconductor substrate, and a bus bar electrode connected to the finger electrode on the semiconductor substrate becomes a low cost and high efficiency solar cell, wherein the bas bar electrode is formed with a recess-and-projection pattern on the surface so that the connector soldered to the bus bar electrode is hard to be peeled off and the shielding of the sunlight by the bus bar electrode is small.

The solar cell of the present invention is a solar cell including at least a semiconductor substrate 5 formed with the PN-junction, a finger electrode 4 formed comb-like on at least one side of the semiconductor substrate 5, and a bus bar electrode 3 connected to the finger electrode 4 on the semiconductor substrate 5, wherein the bus bar electrode 3 is formed with a recess-and-projection pattern 1 on the surface.

The semiconductor substrate 5 is preferably a p-type single crystal silicon substrate doped with gallium, and this allows the solar cell to be manufactured not to cause light degradation and to have extremely high photovoltaic conversion efficiency and be suitable for practical use. First, from the semiconductor substrate 5, a damage layer is removed by etching, and after that, the semiconductor substrate 5 formed with a texture structure for anti-reflection is preferably formed with a PN-junction.

The formation of the PN-junction is preferably performed by the thermal diffusion of n-type impurity such as phosphorus on the light receiving surface side, but it may be performed by a coating diffusion process or an ion implantation method. Here, for sunlight anti-reflection and surface protection, a nitride film is preferably formed on the light receiving surface by plasma CVD method, PVD method and the like.

The finger electrode 4 is preferably formed on the light receiving surface of the semiconductor substrate 5 formed with the PN-junction by screen-printing a conductive paste comb-like and firing. As a result, a low cost and high efficiency solar cell can be produced.

The bus bar electrode 3 is formed so as to be connected to the root of the comb-like finger electrode 4. The bus bar electrode 3 is also preferably formed on the light receiving surface of the semiconductor substrate 5 just like the finger electrode 4 by screen-printing the conductive paste and firing, and when formed by screen-printing and firing integrally with the finger electrode 4, the manufacturing cost can be suppressed, and this is more preferable.

Such a bus bar electrode 3 is formed with the recess-and-projection pattern 1 on the surface, and therefore, the contact area with the solder that attaches the connector increases, so that an anchor effect is obtained, and the adhesive strength between the bus bar electrode 3 and the connector is improved, thereby making the connector hard to be peeled off.

Thus, there is no need to increase the width of the bus bar electrode 3, and therefore, the shielding of the sunlight by the bus bar electrode 3 can be made small, so that a low cost and high efficiency solar cell can be realized.

Particularly, the bus bar electrode 3 is preferably between 1 and 2 mm in width and not more than 80 *µ*m in thickness. This makes the electrode area to shut off the sunlight sufficiently small, and a quantity consumed of the electrode material is also suppressed small, while the electrode surface area sufficiently wide enough to be connected to the connector can be obtained by forming the recess-and-projection pattern 1 on the surface. Incidentally, the thinner the thickness of the bus bar electrode 3 is, the more the electrode material may be preferably saved, but when the thickness is too thin, the resistance of the bus bar electrode 3 is liable to increase, and therefore, the thickness may be, for example, set not less than 10 *µ*m.

The height of a projection 2 relative to a recess of the recess-and-projection pattern 1 is set between 5 and 50 *µ*m, and this allows the height of the electrode to be not too high and the surface area of the bus bar electrode 3 to be made larger by less electrode material.

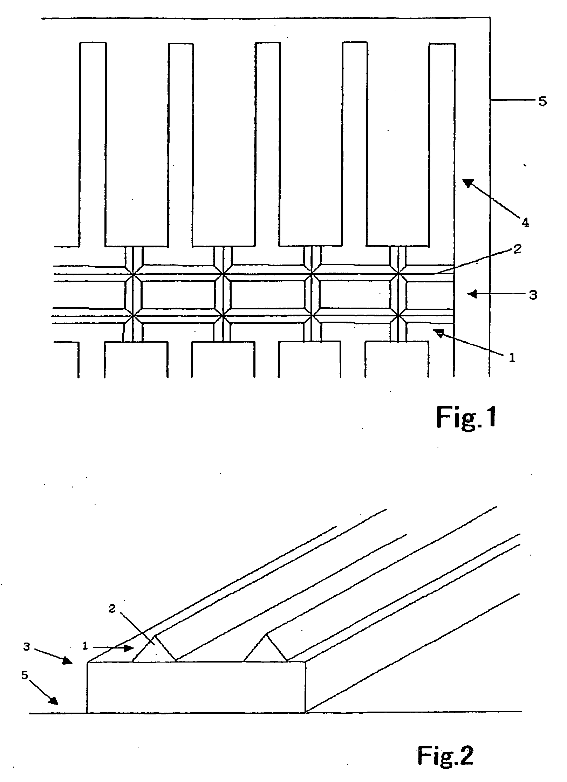

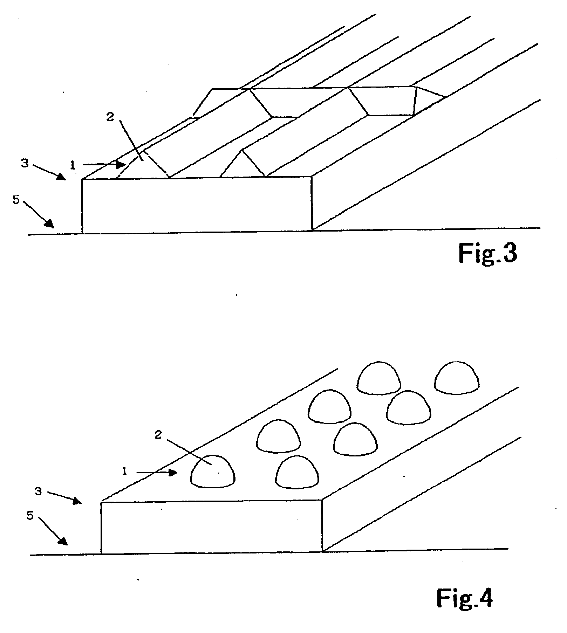

In this manner, when the pattern shape of the recess-and-projection pattern 1 is any shape of the stripe shape such as FIG. 2, the mesh shape such as FIGS. 1 and 3, the honeycomb shape, and the point shape such as FIG.4, the solder flow between the recesses and projections, and the contact area of both sides increases, and the electrode and the solder can be firmly adhered.

The interval between the projections 2 among the recesses and projections is preferably set between 50 *µ*m and 1 mm. This allows the contact area to increase, and the solder can surely flow between the recesses and projections of the electrode surface. This surely improves the adhesive strength, and can exert an anchor effect.

While FIGS.1 to 4 show the case where the pattern shape of the recess-and-projection pattern 1 is formed by the projection 2, if the solder can surely flow between the recesses and projections of the surface of the electrode, not necessarily by the projection 2, but by the recess, the stripe shape, the mesh shape, the honeycomb shape, and the point shape may be formed.

Particularly, when the shape is the mesh shape such as FIGS. 1 and 3 or the honeycomb shape, the difference in the directional character of the difficulty to peel off the connector can be eliminated, and when the projection 2 is formed by the point shape, a quantity consumed of the electrode material can be reduced. The shape of the projection or the recess formed in the point shape may be circle, oval, polygonal or asteroid.

The bus bar electrode 3 comprises two layers. As a result, on the basis of at least one layer of the two layers of the bus electrode 3, the pattern shape of the recess-and-projection pattern 1 can be easily formed.

In particular, by printing the conductive past and firing twice, the bus bar electrode 3 of the two-layered structure is formed, and by at least one printing and firing from among the two printings and firing, the recess-and-projection pattern 1 is preferably formed on the surface of the bus bar electrode 3 of the two-layered structure. As a result, a low cost and high efficiency solar cell can be easily manufactured with the connector soldered to the bus bar electrode 3 not peeled off.

To form the recess-and-projection pattern on the surface of the electrode, when the printing of the bus bar electrode 3 is performed twice separately, a combination of the printing shapes includes, for example, the following three types.
(1) First layer: flat shape
   Second layer: stripe shape, mesh shape, honeycomb shape, and point shape
(2) First layer: stripe shape, mesh shape, honeycomb shape, and point shape
   Second layer: flat shape
(3) First layer: stripe shape, mesh shape, honeycomb shape, and point shape
   Second layer: stripe shape, honeycomb shape, mesh shape, and point shape

For example, preferably, the first layer is printed in the flat shape like (1), and on top of that layer, the second layer is printed in the stripe shape like FIG.2, and the second layer is printed in the mesh shape and the point shape like FIGS. 1, 3, and 4. In this manner, by forming the projection 2 by the printing shape of the second layer, the recess-and-projection pattern 1 can be surely formed on the bus bar electrode 3.

Further, like (2), the first layer is printed in the stripe shape, the mesh shape, the honeycomb shape, and the point shape, and on top of the first layer, the second layer is printed in the flat shape, so that the recess-and-projection pattern may be formed, and in this case, the second layer can be prevented from being peeled off from the first layer.

Further, like (3), the first layer and the second layer are not formed in the flat shape, respectively, but as a result of being superposed with each other, the recess-and-projection pattern can be also formed on the surface of the bus bar electrode 3.

When the bus bar electrode 3 of the solar cell of the present invention thus configured is soldered with the connector and used, the connector is hard to be peeled off, and moreover, the shielding of the sunlight by the bus bar electrode 3 is small, and electric power can be efficiently obtained with a low-cost. The connector to be soldered may be a connector that directly takes out the power from one piece of the solar cell or an inter-connector that takes out the power by mutually connecting a plurality of solar cells.

While the present invention will be more specifically explained by showing an example and a comparative example, the present invention is not limited to these examples.

### (Example and Comparative Example)

A p-type single crystal solar cell silicon substrate (100 mm square, plane direction {100}, substrate thickness 300 *µ*m, resistivity 0.5 Ωcm) doped with a group III element gallium as an impurity element was etched by potassium hydrate aqueous solution, thereby removing a damage layer. Further, by potassium hydrate aqueous solution mixed with IPA, a texture structure serving as an anti-reflection structure was formed.

By thermal diffusion using a POCl₃ liquid source at the light receiving surface side, an n-region doped with phosphorus of a group V element as impurity was fabricated on the light receiving surface. Here, for both purposes of the sunlight anti-reflection and the surface protection, the nitride film of 70 nm in thickness was formed on the light receiving surface by a plasma CVD method. Further, for the back surface (surface opposite to the light receiving surface), the conductive paste containing aluminum particles was printed on the whole surface.

On the light receiving surface, the conductive paste containing silver particles was printed in the shapes of the finger electrode and the bus bar electrode, and was fired for three minutes at 700°C, thereby completing the solar cell.

Here, the bus bar electrode was printed twice to be superposed. The first layer (together with the finger electrode) was printed in the flat shape, and the second layer was printed in the mesh shape like FIGS. 1 and 3 (example). The width of the bus bar electrode was 1.5 mm, and the electrode thickness of the first layer was defined as 20 *µ*m, and the electrode thickness of the second layer was defined as 30 *µ*m (which becomes the recess-and-projection difference). The meshed line width of the second layer was 100 *µ*m, and the interval of the lines was defined as 200 *µ*m.

For comparison, the solar cell fabricated in the flat shape was prepared for the second layer, similar to the first layer (comparative example).

Finally, the output characteristics of the solar cell fabricated by using a solar simulator (light intensity: 1 kW/m², spectrum: AM 1.5 global) were measured.

Further, the inter-connector was soldered on the bus bar, and a peeling probability when the inter-connector was pulled in the normal direction of the substrate surface by a force of 2 N was measured.

The output characteristics and the peeling probability thus obtained are shown in the following Table 1.

**[Table 1]**

| | Example | Comparative example |
|---|---|---|
| | (2^{nd} layer: mesh) | (2nd layer: flat) |
| Short-circuit current (mA/cm²) | 35.3 | 34.9 |
| Open-circuit voltage (mV) | 621.2 | 620.7 |
| Series resistance (Ω·cm²) | 0.54 | 0.51 |
| Fill factor (%) | 78.1 | 78.6 |
| Conversion efficiency (%) | 17.1 | 17.0 |
| Height of projection relative to recess of bus bar electrode surface (*µ*m) | 30 | 0 |
| Event probability of peeling off of inter-connector (%) | 0 | 27 |

Since the event probability of the peeling off of the inter-connector of the example was improved to a large extent as compared to the comparative example, by soldering the connector to the bus bar electrode of the solar cell of the present invention, it was confirmed that the connector became hard to be peeled off.

Further, from the measurement result of the output characteristics, it was confirmed that the solar cell of the present invention having no need to enlarge the electrode width of the bus bar electrode has the shielding of the sunlight not enlarged and it is hardly affected in its efficiency.

The present invention is not limited to the embodiment. The embodiment is illustrative, and has substantially the same configuration as the technical idea disclosed in the scope of the claims of the present invention, and any configuration exerting the same operational effect is contained in the technical scope of the present invention.

For example, though an explanation has been made on the formation of the finger electrode and the bus bar electrode by the screen printing by using the conductive paste, the present invention is not limited thereto, and the fact that the connector soldered to the bus bar electrode easily peels off is also observed when the electrode is formed by vacuum deposition and the like, and needless to mention, an incidence rate of the peeling off can be reduced by the anchor effect through the application of the present invention.

Further, as described above, though an explanation has been made on the formation of the bus bar electrode on the light receiving surface side only, the electrode may be formed on both surfaces, and the present invention may be applied not only on the light receiving surface, but also on the bus bar electrode of the back surface, and can exert the effect.

## Claims

1. A solar cell, comprising at least: a semiconductor substrate (5) formed with a PN-junction, a finger electrode (4) formed comb-like on at least one surface of the semiconductor substrate, and a bus bar electrode (3) connected to the finger electrode on the semiconductor substrate, wherein the bus bar electrode comprises two layers and is formed with a recess-and-projection pattern (1) on a surface thereof, wherein the pattern shape of the recess-and-projection pattern is formed on the basis of at least one layer of the two layers of the bus bar electrode, wherein the height of a projection (2) relative to a recess of the recess-and-projection pattern (1) is set to 5 to 50 µm, and the pattern shape of the recess-and-projection pattern (1) is any shape of a honeycomb shape, and a point shape.

2. The solar cell according to claim 1, wherein the interval between the projections (2) of the recess-and-projection pattern (1) is set of 50 µm to 1 mm.

3. The solar cell according to claim 1 or 2, wherein the bus bar electrode is 1 to 2 mm in width, and is not more than 80 µm in thickness.

4. The solar cell according to any of claim 1 to 3, wherein the bus bar electrode is printed with a conductive paste and fired.

5. The solar cell according to any of claims 1 to 4, wherein the semiconductor substrate is a p-type single crystal silicon substrate doped with gallium.

6. A manufacturing method for a solar cell, comprising at least the steps of forming a PN-junction on a semiconductor substrate (5), and then forming a comb-like finger electrode (4) and a bus bar electrode (3) connected to the finger electrode on at least one surface of the semiconductor substrate, wherein the bus bar electrode of a two-layered structure is formed by printing a conductive paste and firing twice, and at least by one printing and firing of the two printings and firing, a recess-and-projection pattern (1) is formed on the bus bar electrode of the two-layered structure, wherein the height of a projection (2) relative to a recess of the recess-and-projection pattern (1) is set to 5 to 50 µm, and the pattern shape of the recess-and-projection pattern (1) is any shape of a honeycomb shape, and a point shape.

## Patentansprüche

1. Solarzelle, umfassend mindestens: ein Halbleitersubstrat (5), das mit einem PN-Übergang, einer Fingerelektrode (4), die kammartig auf mindestens einer Oberfläche des Halbleitersubstrats ausgebildet ist, und einer Sammelschienenelektrode (3) gebildet ist, welche mit der Fingerelektrode auf dem Halbleitersubstrat verbunden ist, wobei die Sammelschienenelektrode zwei Schichten umfasst und mit einem Aussparungs- und Vorsprungsmuster (1) auf einer Oberfläche derselben ausgebildet ist, wobei die Musterform des Aussparungs- und Vorsprungsmusters auf der Basis mindestens einer Schicht der zwei Schichten der Sammelschienenelektrode ausgebildet ist, wobei die Höhe eines Vorsprungs (2) relativ zu einer Aussparung des Aussparungs- und Vorsprungsmusters (1) auf 5 bis 50 µm festgesetzt ist und die Musterform des Aussparungs- und Vorsprungsmusters (1) irgendeine Form aus einer Bienenwabenform und einer Punktform ist.

2. Solarzelle nach Anspruch 1, bei der der Zwischenraum zwischen den Vorsprüngen (2) des Aussparungs- und Vorsprungsmusters (1) auf 50 µm bis 1 mm festgesetzt ist.

3. Solarzelle nach Anspruch 1 oder 2, bei der die Sammelschienenelektrode 1 bis 2 mm breit ist und nicht mehr als 80 µm dick ist.

4. Solarzelle nach irgendeinem der Ansprüche 1 bis 3, bei der die Sammelschienenelektrode mit einer Leitfähigkeitspaste gedruckt und eingebrannt ist.

5. Solarzelle nach irgendeinem der Ansprüche 1 bis 4, bei der das Halbleitersubstrat ein Einkristall-Siliciumsubstrat vom p-Typ ist, das mit Gallium dotiert ist.

6. Herstellungsverfahren für eine Solarzelle, umfassend mindestens die Schritte der Bildung eines PN-Übergangs auf einem Halbleitersubstrat (5) und dann das Bilden einer kammartigen Fingerelektrode (4) und einer Sammelschienenelektrode (3), die mit der Fingerelektrode verbunden ist, auf mindestens einer Oberfläche des Halbleitersubstrats, wobei die Sammelschienenelektrode mit zweischichtiger Struktur durch Drucken einer Leitfähigkeitspaste und zweimaliges Einbrennen gebildet wird, und mindestens durch Eindrucken und Einbrennen der beiden Druckvorgänge und Einbrennvorgänge ein Aussparungs- und Vorsprungsmuster (1) auf der Sammelschienenelektrode der zweischichtigen Struktur gebildet wird, wobei die Höhe eines Vorsprungs (2) relativ zu einer Aussparung des Aussparungs- und Vorsprungsmusters (1) auf 5 bis 50 µm eingestellt wird und die Musterform des Aussparungs- und Vorsprungsmusters (1) irgendeine Form aus einer Bienenwabenform und einer Punktform ist.

## Revendications

1. Cellule solaire, comprenant au moins : un substrat semi-conducteur (5) formé avec une jonction PN, une électrode en forme de doigt (4) façonnée en forme de peigne sur au moins une surface du substrat semi-conducteur, et une électrode de barre omnibus (3) connectée à l'électrode en forme de doigt sur le substrat semi-conducteur, dans laquelle l'électrode de barre omnibus comprend deux couches et est formée avec un motif en renfoncements-et-saillies (1) sur une surface de celle-ci, dans laquelle la forme de motif du motif en renfoncements-et-saillies est formée sur la base d'au moins une couche parmi les deux couches de l'électrode de barre omnibus, dans laquelle la hauteur d'une saillie (2) par rapport à un renfoncement du motif en renfoncements-et-saillies (1) est fixée à 5 à 50 µm, et la forme de motif du motif en renfoncements-et-saillies (1) est une forme quelconque parmi une forme en nid d'abeille, et une forme de point.

2. Cellule solaire selon la revendication 1, dans laquelle l'intervalle entre les saillies (2) du motif en renfoncements-et-saillies (1) est fixé entre 50 µm et 1 mm.

3. Cellule solaire selon la revendication 1 ou 2, dans laquelle l'électrode de barre omnibus est de 1 à 2 mm de largeur, et ne dépasse pas 80 µm d'épaisseur.

4. Cellule solaire selon l'une quelconque des revendications 1 à 3, dans laquelle l'électrode de barre omnibus est imprimée avec une pâte conductrice et cuite.

5. Cellule solaire selon l'une quelconque des revendications 1 à 4, dans laquelle le substrat semi-conducteur est un substrat de silicium monocristallin de type p dopé avec du gallium.

6. Procédé de fabrication d'une cellule solaire, comprenant au moins les étapes de formation d'une jonction PN sur un substrat semi-conducteur (5), puis de formation d'une électrode en forme de doigt comme un peigne (4) et d'une électrode de barre omnibus (3) connectée à l'électrode en forme de doigt sur au moins une surface du substrat semi-conducteur, dans laquelle l'électrode de barre omnibus d'une structure à deux couches est formée par impression d'une pâte conductrice et cuisson à deux reprises, et au moins par une impression et cuisson des deux impressions et cuisson, un motif en renfoncements-et-saillies (1) est formé sur l'électrode de barre omnibus de la structure à deux couches, dans lequel la hauteur d'une saillie (2) par rapport à un renfoncement du motif en renfoncements-et-saillies (1) est fixée à 5 à 50 µm, et la forme de motif du motif en renfoncements-et-saillies (1) est une forme quelconque parmi une forme en nid d'abeille, et une forme de point.
